# EUROPEAN PATENT APPLICATION

(11) **EP 4 576 196 A1**
(43) Date of publication of application: **25.06.2025**
(21) Application number: 24219194.8
(22) Date of filing: 11.12.2024
(51) Int. Cl.: H01L 23/31, H01L 23/495, H01L 23/58

(54) **METHODS FOR BATTERY CONNECTION IN MICROELECTRONIC PACKAGES**

(30) Priority: 20.12.2023 US 202318390400
(71) Applicant: NXP USA, Inc., Austin, TX 78735 (US)
(72) Inventor: KANTH, Namrata, 5656AG Eindhoven (NL); HOOPER, Stephen Ryan, 5656AG Eindhoven (NL); SAKLANG, Chayathorn, 5656AG Eindhoven (NL); VINCENT, Michael B, 5656AG Eindhoven (NL); MUDDIMAN, Matthew Wayne, 5656AG Eindhoven (NL)
(74) Representative: Hardingham, Christopher Mark

(57) **Abstract**

A self-powered microelectronic semiconductor device includes low temperature interconnection and encapsulation materials to enable integration of a battery with the microelectronics package during manufacture. The package includes a partially exposed leadframe or leads of a substrate for connecting the battery. The battery includes one or more terminal connectors that can either be manufactured by the battery vendor or externally attached using spot/laser or resistance welding. The steps of connecting the battery to the package are performed after the microelectronic package assembly to ensure the battery does not experience any high temperatures from the package assembly process. Cavities are formed in an overmolded molding compound to expose the leadframe or battery pads for electronic connection. A low temperature electrically conductive bonding agent is used to create the electrical and mechanical bond of the battery tabs to the leadframe. A low temperature encapsulant is then applied over the package and mounted battery.

## Description

### TECHNICAL FIELD

The embodiments of the present disclosure relate to the design and manufacturing of self-powered microelectronic semiconductor packages and, more specifically, to systems and methods for low-temperature manufacturing of encapsulated microelectronic packages with self-contained batteries.

### BACKGROUND

Semiconductor devices are often found in a large spectrum of electronic products-from home monitoring devices like smoke detectors and alarms to home appliances like sewing machines and smart doorbells, from automobiles to cellular telephones, and so on. Many of these semiconductor devices may include sensitive systems and may be produced in high volumes to drive costs down. In example manufacturing processes, multiple semiconductor devices can be manufactured as a strip or a sheet and then "singulated" through cutting processes that separate each device from the others. The composite product of such processes, known as a "package," may comprise active and passive microelectronic components, integrated circuits, bonding wires, etc., mounted on a printed circuit board (PCB) or other substrate.

Many of these devices are powered by a battery that, due to size constraints for devices in these applications, must be very small. Non-rechargeable lithium 3V "button batteries," ranging in size from about 10mm to about 30mm in diameter, are commonly used due to their low cost, high commercial availability, and relatively high capacity-to-volume ratio. Typically, the battery is installed after fabrication of the package, and is externally mounted via a socket, tabs or clips, or other conductive mounting assembly. This external mounting adds bulk to the device and can decrease its reliability; moreover, the step of mounting the battery from outside the device interrupts the assembly flow of high-volume production processes. It would be advantageous to mount commonly-used button batteries internally in the semiconductor device, using a process that can be integrated into the semiconductor assembly flow.

### SUMMARY

This disclosure provides package designs, systems, and methods for manufacturing self-powered microelectronic semiconductor devices, including low temperature interconnection and encapsulation processes that integrate the button battery into the semiconductor package without degrading the battery's performance. A battery with terminals formed by integrated or welded tabs is selected for use in the present devices. The package design may include selectively oriented apertures disposed through conductive leads, such as legs of a leadframe or battery pads in a substrate package, which correspond to the locations of the battery's tabs when downwardly projecting away from the battery. After die and passive components are mounted on the leadframe or substrate, but before overmolding, temporary structures, such as press-fit pins or similar interconnects, are inserted into or disposed over the apertures. A molding compound is applied and the temporary structures are then removed, leaving cavities in the mold disposed over the apertures. In other embodiments, such cavities may be formed into the molding compound after it has cured, such as through cutting, laser ablation, and the like.

A low temperature, conductive bonding agent, such as electrically conductive adhesive (ECA), is deposited into the channels formed by the cavities and apertures. The battery is then mounted over the molding compound, with the tabs extending into the channels and into contact with the bonding agent, which is allowed to set or is cured. Then, the package and mounted battery are encapsulated or coated using a low-temperature encapsulant or conformal coating. The encapsulant is allowed to cure, and the individual semiconductor devices may then be singulated.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1A is a top view of an example self-powered encapsulated microelectronics package with connected battery in accordance with this disclosure.
FIG. 1B is a cross-sectional rear view of the microelectronics package of FIG. 1A taken along line 1B-1B of FIG. 1A.
FIG. 1C is a cross-sectional front view of the microelectronics package of FIG. 1A taken along line 1C-1C of FIG. 1A.
FIG. 2 is a cross-sectional rear view of another embodiment of a self-powered encapsulated microelectronics package with connected battery in accordance with this disclosure.
FIGS. 3A and 3B are a flowchart depicting an example method for manufacturing a self-powered encapsulated microelectronics package with connected battery in accordance with this disclosure, with diagrammatic illustrations of various steps of the method.
FIG. 4 is a flowchart depicting another example method for manufacturing a self-powered encapsulated microelectronics package with connected battery in accordance with this disclosure, with diagrammatic illustrations of various steps of the method.

### DETAILED DESCRIPTION

It will be readily understood that the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

Embodiments of this disclosure may present in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

For simplicity, the described features, advantages, and characteristics of the invention are described throughout this specification may be described as being implemented within an embedded device, semiconductor device or package, microelectronic device, etc., including one or more microprocessors, other processing units, programmable and/or non-programmable memory, and other integrated circuits as well as individual circuit components and other pieces of electronic equipment, but the present devices and methods may be implemented in other electronic devices for which the described package designs, systems, and methods of manufacture would be useful.

In general, the embodiments described herein provide for the production of self-powered microelectronic semiconductor devices using package designs and low temperature interconnection and encapsulation processes that integrate a button battery into the semiconductor package without degrading the battery's performance. The battery in these embodiments may be any suitable consumer electronics-grade battery that can power and is compatible with the microelectronics of the package. Nevertheless, the disclosure contemplates production limitations and considerations such as: battery size vis-à-vis package size and desired device size; battery cost; battery temperature tolerance; and battery terminal connector configuration. In various embodiments, the battery terminal connectors are "tabs," with the positive and negative terminals of the battery each contacting at least one of the tabs. A tab is a thin metal contact integrated into or attached to one of the battery terminals and extending away from the battery, such as downward in the direction of mounting. In some embodiments, the tabs may be made of or plated with nickel and/or tin, to enable reflow connection via soldering.

The consumer grade batteries that are the subject of this disclosure are intolerant of the temperatures applied during certain phases of device production. For example, commonly available button batteries operate at a limited temperature range of about -40C to about 125C; the melting point of lithium is 180C, and the boiling temperature of electrolytes used in lithium batteries can range from 80C to 200C. Exposing the batteries to the temperatures used in various stages to the semiconductor package assembly (e.g., molding > 175C, wirebond > 150C, reflow temperature 260C) can destroy the batteries or severely degrade their performance.

As provided herein, the manufacturing methods include any suitable steps for assembling the microelectronics onto a leadframe or substrate of the package, such as etching, die deposition, wire bonding, reflow, etc., as well as the novel molding process described below, all of which are performed before the battery is introduced into the package. Once the battery is introduced, the subsequent steps are performed using materials that are workable at temperatures that will not degrade the battery. In particular, the low-temperature steps include bonding the battery to the package leads and encapsulating the package. In various embodiments, these steps involve the use of a low temperature bonding agent and a low temperature electronics encapsulant, respectively.

In the illustrated examples, the bonding agent is described as electrically conductive adhesive (ECA). The ECA may be any suitable ECA that is compatible with both the package leads and the battery tabs, and that is curable at a temperature that does not exceed the maximum temperature tolerated by the battery to be installed in the device. For example, silver-based epoxies that cure at temperatures of about 80C or below may be used with BR-A or CR-W type lithium batteries, which have a maximum operating temperature of about 125C. Additional example ECAs that are suitable for common consumer button/coin batteries include AA-Duct S80 from ATOM, MG8331D-14G from MG Chemical, and LOCTITE ABLESTIK 967-1 from Henkel Adhesives. Further, the low temperature bonding agent is not limited to ECAs, and the disclosure contemplates any suitable alternative material that is conductive, is workable at temperatures that will not damage the battery, and forms a permanent bond between the leads and the tabs. For example, the bonding agent may be a low-temperature solder paste or solder alloy (e.g., tin/bismuth); the steps of depositing and curing the ECA as described below may be replaced with, for example, the steps of flowing the solder into the channels and allowing it to cool once the battery is mounted. The encapsulant may be any non-conductive material that is suitable for encapsulating electronics packages and workable at the described low temperatures. Non-limiting examples of such encapsulants include silicone or urethane-based potting material, room temperature vulcanization (RTV) sealants, low cure temperature two-part epoxies, various thermoplastic polymers, UV-curable damming or filling materials, and the like. Alternatively, the encapsulant may be a conformal coating applied over the components of the device to an encapsulating effect. The choice of encapsulant or conformal coating may depend on the intended application(s) of the device. For example, automotive products may need thick encapsulants since they have to withstand vibration and shock, while consumer and home products may only need environmental insulation which can be fulfilled with conformal coatings.

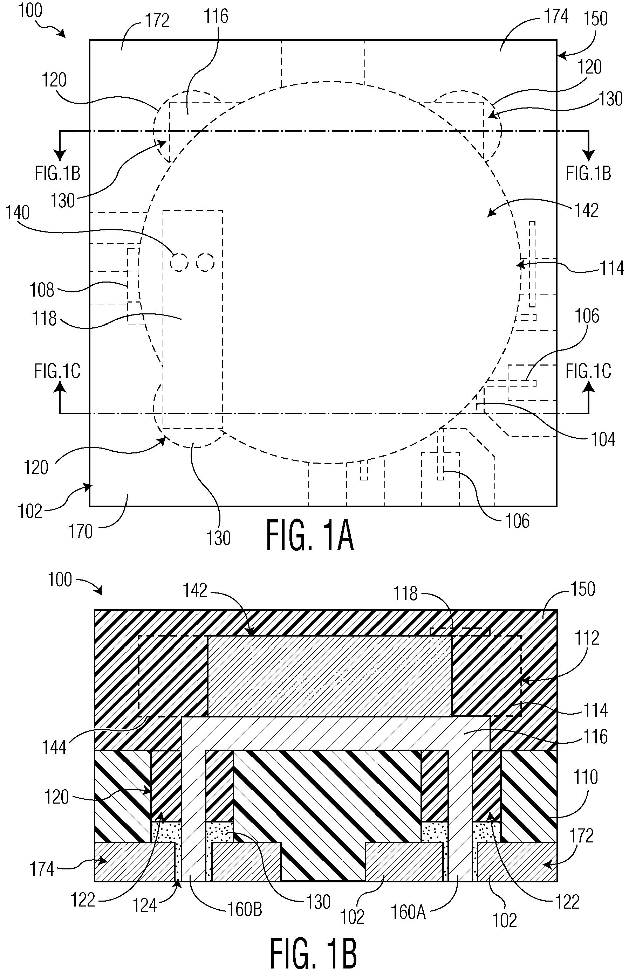

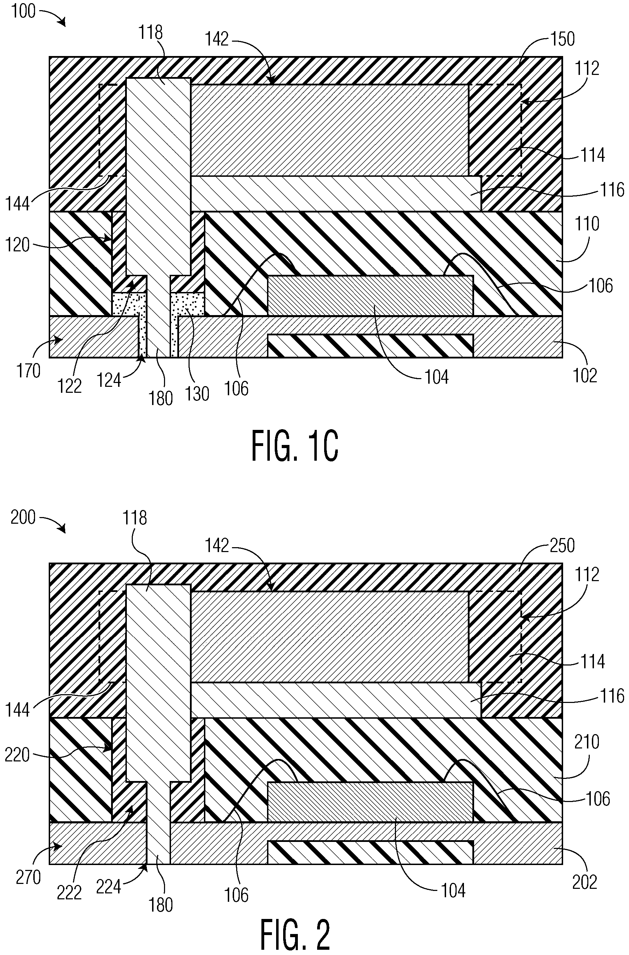

FIGS. 1A, 1B, and 1C illustrate an example self-powered microelectronic semiconductor device 100 manufactured as described herein; the illustrations include the top-down view of FIG. 1A and simplified side-on cross-sectional views provided in FIG. 1B and FIG. 1C to illustrate interconnects of a leadframe 102 with a battery assembly 112. The device 100 includes a microelectronics package comprising the leadframe 102, one or more electronic components electrically connected to the leadframe 102, and a layer of molding compound 110 deposited, as further described below, over the electronic components and onto/through the leadframe 102 to protect the components and the electrical connections. The leadframe 102 is a conductive metal layer that may serve as the base of a semiconductor device or may be deposited on a PCB or another substrate that serves as the base. The leadframe 102 may be a metal sheet or film etched into electrically isolated segments, referred to herein as "legs," that serve as conductive leads to facilitate control of the signal paths between various components electrically connected to different legs of the leadframe 102.

It will be understood that, while the example device 100 and its attendant description include a novel leadframe 102, the present disclosure is applicable to, and contemplates, any semiconductor package that is overmolded and that has an arrangement of conductive leads to which a battery assembly can be affixed as described herein, including by accommodating apertures through the conductive leads, in various embodiments. For example, thick-film, thin-film, and PCT-based substrate packages comprising layers of insulating and conducting materials interconnected through traces and vias may include pads or similar conductive leads that include apertures as described herein with respect to the legs of a leadframe.

The electronic components that may be electrically connected to the leadframe 102 before the molding process include microcontrollers, sensors, wireless transmitters/receivers, application-specific and other integrated circuits, semiconductor devices, basic components such as capacitors and resistors, and the like. The components can be directly connected (e.g., via soldering), wire-bonded, etc., to bond the components in electrical contact with the leadframe 102. For purposes of example, the illustrated device 100 includes an integrated circuit 104 attached via bonding wires 106 to the leadframe 102, and a passive device 108 directly bonded to the leadframe 102. Once the components are attached, an insulating, protective molding compound 110 is deposited over the components and, except as described below, the leadframe 102. The molding compound 110 may be any suitable material used in semiconductor molding processes such as transfer, compression, or injection molding, flow deposition, etc.

However, the present disclosure provides a novel modification of suitable state-of-the-art molding processes. In various embodiments, as shown in FIGS. 1B and 1C, a plurality of structures (not shown) are placed on the leadframe 102 so that the molding compound 110 settles into a layer around the structures; when the molding compound 110 is hardened or cured, the structures are removed, leaving a plurality of cavities 122 in the molding compound 110 extending entirely through the layer of molding compound 110 and thus leaving a portion of the leadframe 102 exposed beneath each cavity 122. The cavities 122 are positioned so that terminal connectors 116, 118 of the battery assembly 112 may pass therethrough into electrical contact with the leadframe 102. In some embodiments, there are at least two cavities 122, each receiving one of the positive terminal or negative terminal connectors of the battery assembly 112.

In the illustrated example device 100, the example battery assembly 112 comprises a "button" or "coin" battery 114, as described above, having a positive terminal 142 on the top surface of the battery 114 and a negative terminal 144 on the bottom surface of the battery 114. The battery assembly 112 further comprises a first terminal connector 116 affixed to or integral with the battery 114 and in electrical contact with the negative terminal 144, and a second terminal connector 118 affixed to or integral with the battery 114 and in electrical contact with the positive terminal 142. The terminal connectors 116, 118 may comprise the same material as the outer casing of the battery 114, or may be a different conductive metal as described above. In some embodiments, one or both of the terminal connectors 116, 118 may be welded (e.g., via spot or laser welds 140) to the battery 114 by the battery manufacturer or as a pre-installation step of the present production methods. One or both of the terminal connectors 116, 118 may be bent one or more times, so that a first portion abuts the horizontal surfaces of the battery 114, and the other portion(s) form one or more tabs extending away (e.g., downward) from the battery 114. For example, the illustrated first terminal connector 116 comprises a first tab 160A and a second tab 160B, and the second terminal connector 118 comprises a single tab 180. The tabs may provide both electrical connection and permanent mounting of the battery assembly 112 within the device 100.

In the illustrated device 100, when the battery assembly 112 is installed over the molding compound 110, each of the three tabs 160A, 160B, 180 extend through a corresponding cavity 122 and electrically connect to different legs 170, 172, 174 of the leadframe 102 that are electrically isolated from each other. In some embodiments, one or more of the tabs 160A-B, 180 may directly contact the leadframe 102 at the bottom of the corresponding cavity 122, or may extend substantially all (e.g., 90%) of the way through the corresponding cavity 122 and into contact with ECA 130 deposited on the leadframe 102 at the bottom of the cavity 122. In other embodiments, such as in the illustrated device 100, the leadframe 102 may include a plurality of apertures 124 disposed through the leadframe 102 and positioned to receive the tabs 160A-B, 180. Each aperture 124 thus may be aligned with a corresponding cavity 122, forming a tab channel 120 that allows the tabs 160A-B, 180 to extend into or through the leadframe 102. In some embodiments, the electrical connection and the mechanical bonding of the battery assembly 112 to the microelectronics package is achieved using a low temperature, conductive bonding agent, such as electrically conductive adhesive (ECA) 130, deposited into the tab channels 120. The ECA 130 may fill or otherwise be disposed within any spaces between the tabs 180, 160A, 160B and the respective legs 170, 172, 174 of the leadframe 102. The ECA 130 is cured to finalize the connections, bonding to contacted surfaces of the leadframe 102, terminal connectors 166, 118, and molding compound 110 forming the walls of the cavities 122.

A low-temperature encapsulant 150 is disposed over the entire package, including the now mounted battery assembly 112. As shown, the encapsulant 150 may fill the remainder of the cavities 122 and the insulative spaces between legs of the leadframe 102 while settling as a layer (e.g., over a strip or sheet of devices 100). The encapsulant 150 is allowed to cure, and the individual semiconductor devices 100 may then be singulated (i.e., individually detached from the larger fabrication (e.g., strip or sheet of devices 100) using any suitable singulation process). As noted above, in some embodiments the encapsulant 150 may be replaced with a suitable conformal coating having deposition and curing process temperatures that do not exceed the maximum temperature tolerated by the selected battery 114.

FIG. 2 illustrates another example semiconductor device 200 that is similar to the device 100 described above and illustrated in FIGS. 1A-C but comprises modifications to the leadframe 102 and, in some embodiments, to the molding compound 110 and/or the encapsulant 150 of the above-described device 100. In the device 200 of FIG. 2, a leadframe 202 may comprise apertures 224 (e.g., in a leg 270 of the leadframe 202) that each receive one of the tabs (e.g., tab 180) of the battery assembly 112 as described above. The width or diameter of the aperture 224 may be selected based on the width or diameter of the corresponding tab 180 so that the terminal 118 of the battery assembly 112 makes electrical contact with the leadframe 202 and also is mechanically retained within the aperture 224 by friction fit. Accordingly, the ECA or other bonding agent used in the device 100 described above may be omitted from the example device 200 of FIG. 2. A cavity 222 may be formed in the molding compound 210 as described above, creating a tab channel 220 comprising the cavity 222 and the aperture 224 aligned therewith, as described above. The encapsulant 250 may be deposited over the microelectronics package and mounted battery assembly 112 as described above.

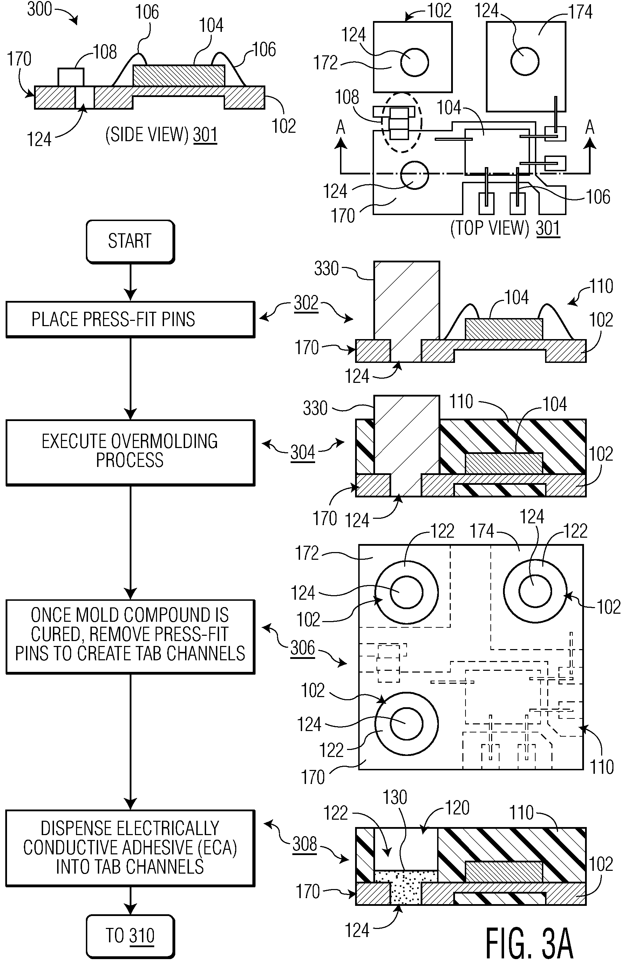

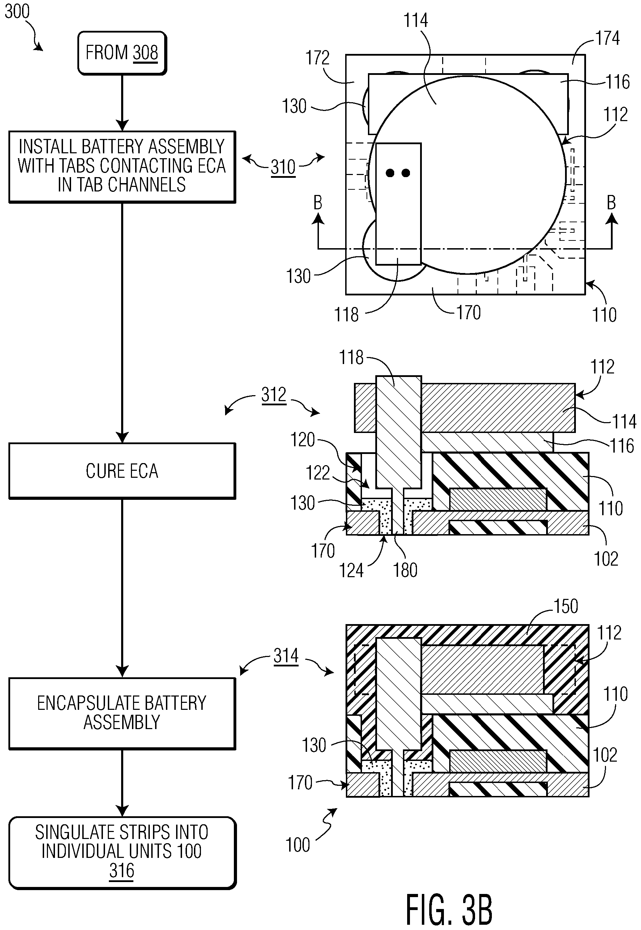

Referring to FIGS. 3A and 3B, an example method 300 for fabricating the present microelectronic semiconductor devices is provided with reference to the example device 100 of FIGS. 1A-C. The method 300 begins with the provision of a fabricated microelectronics package 301 comprising the leadframe 102 with apertures 124 through the legs 170, 172, 174; the high-temperature microelectronic component mounting and wirebonding processes provide the components 104, 106, 108 attached to the leadframe 102. At 302, a plurality of press-fit pins 330 are inserted into or otherwise positioned over the apertures 124 . At 304, with the pins 330 in place, an overmolding process is executed, depositing the molding compound 110 over the leadframe 102 and components, and surrounding the press-fit pins 330. The molding compound 110 is cured, and at 306 the pins 330 are removed, creating the cavities 122 in the molding compound 110; each cavity 122 is positioned over a corresponding aperture 124, together forming the tab channels 120. At 308, the ECA 130 or other bonding agent is dispensed into the tab channels 120. The ECA 130 is allowed to settle in contact with the leadframe 102.

The ECA 130 has a depth that allows the tabs of the battery assembly 112 to contact the ECA 130 when, at 310, the battery assembly 112 is installed over the molding compound 110. At 312, the ECA 130 is cured, at low temperatures, in contact with the corresponding tab 180 and corresponding leg 170 of the leadframe 102, creating both electrical and mechanical bonds. At 314, a low temperature encapsulating process is executed, depositing the encapsulant 150 over the battery assembly 112 and the microelectronics package. Once the encapsulant 150 is hardened or cured, at 316 the strips or sheets of devices 100 can be singulated.

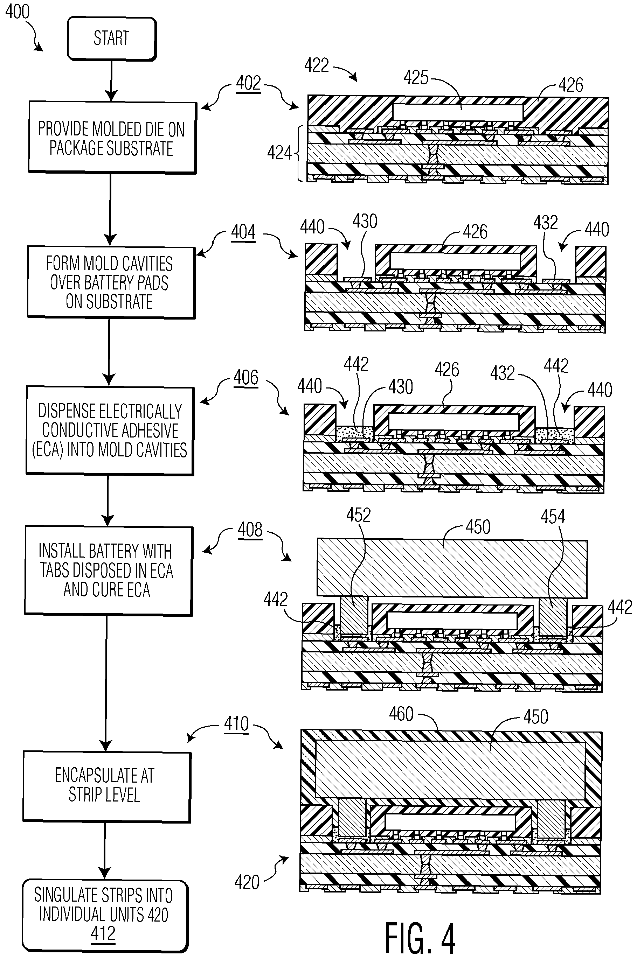

FIG. 4 provides another example method 400 for fabricating another example self-powered microelectronic semiconductor device 420 in accordance with the present disclosure. At 402, the method 400 begins with the provision of an assembled and overmolded microelectronic semiconductor package 422. The package 422 comprises a multilayer package substrate 424, one or more microelectronic components 425 electrically connected to the package substrate 424, and a layer of molding compound 426 deposited over the package substrate 424 and components 425 as described above and as known in the art. At 404, a plurality of battery pads 430, 432 are exposed by forming a plurality of cavities 440 through the molding compound 426, each over one of the battery pads 430, 432. The cavities 440 may be formed by any suitable molding compound removal process, such as laser ablation. Alternatively, the cavities 440 may be formed during the molding process, such as with the press-fit pin application described above, film-assisted molding procedures, or another suitable procedure. After 404, the battery pads 430, 432 will be exposed for connecting of a battery 450.

At 406, ECA 442 or another suitable low temperature bonding agent is dispensed into the cavities 440, effectively coating the battery pads 430, 432. At 408, the battery 450 is installed by inserting corresponding terminal connector tabs 452, 454 through the cavities 440 into contact with the ECA 442 and curing the ECA 442 at low temperatures. This forms the electrical and mechanical bonds between the battery 450 and the package 422, without damaging the battery 450. At 410, a low temperature encapsulating process is executed, depositing an encapsulant 460 over the battery 450 and the microelectronics package 422. Once the encapsulant 460 is hardened or cured, at 412 the strips or sheets of devices 420 can be singulated.

The present disclosure describes various implementations of a self-powered microelectronic semiconductor device and methods of manufacture that prevent damage to a battery of the device. In some aspects, the disclosure provides a method of manufacturing a semiconductor device that includes the steps of: providing a microelectronics package including one or more microelectronic components affixed to a leadframe; forming a plurality of cavities in a molding compound deposited over the leadframe and the one or more microelectronic components, the plurality of cavities each extending through the molding compound to expose a portion of the leadframe; affixing a battery assembly to the leadframe, the battery assembly including a battery having a first terminal and a second terminal, a first terminal connector attached to the first terminal of the battery and extending through a first of the plurality of cavities to affix to a first leg of the leadframe, and a second terminal connector attached to the second terminal of the battery and extending through a second of the plurality of cavities to affix to a second leg of the leadframe; and, depositing a low temperature encapsulant over the molding compound, the battery assembly, and the leadframe to encapsulate the semiconductor device. The method may further include affixing the one or more microelectronic components to the leadframe.

Forming the plurality of cavities may include the steps of: positioning a plurality of structures on an upper surface of the leadframe at locations that correspond to at least the first and second terminal connectors of the battery assembly; depositing the molding compound in a layer over the leadframe and the one or more microelectronic components, the plurality of structures extending above the layer; curing the molding compound; and, removing the plurality of structures, leaving the plurality of cavities through the layer. The battery has a tolerance for temperatures up to a maximum temperature, and affixing the battery assembly to the leadframe may include the steps of: depositing an electrically conductive low temperature bonding agent into the first cavity and into the second cavity, the bonding agent contacting the leadframe; inserting the first terminal connector and the second terminal connector into the first and second cavities, respectively, into contact with the bonding agent; and, causing the bonding agent to bond the first and second terminals in electrical and mechanical contact with the leadframe at a temperature that does not exceed the maximum temperature. The low temperature bonding agent may be electrically conductive adhesive (ECA), and causing the bonding agent to bond the first and second terminals may include curing the ECA. Alternatively, the low temperature bonding agent may be a low temperature solder; the first and second terminal connectors may include tin plating, and causing the bonding agent to bond the first and second terminals may include reflowing the solder and the tin plating into each other.

The leadframe may include a plurality of apertures including a first aperture disposed through the first leg and a second aperture disposed through the second leg. Forming the plurality of cavities may include forming the first cavity over the first aperture to create a first channel and forming the second cavity over the second aperture to create a second channel. Affixing the battery assembly to the leadframe may include inserting the first terminal connector through the first channel into the first aperture and inserting the second terminal connector through the second channel into the second aperture. Affixing the battery assembly to the leadframe may further include inserting the first and second terminal connectors into the first and second apertures, respectively, to secure the first and second terminal connectors to the leadframe by friction fit. Alternatively, affixing the battery assembly to the leadframe may further include the steps of: depositing an electrically conductive low temperature bonding agent into the first channel and into the second channel, the bonding agent contacting the leadframe within the first and second apertures, respectively, and the bonding agent contacting the first and second terminal connectors when the first and second terminal connectors are inserted into the first and second apertures, respectively; and, causing the bonding agent to bond the first and second terminal connectors in electrical and mechanical contact with the leadframe. In this aspect, forming the plurality of cavities may include the steps of: inserting a first pin into the first aperture and a second pin into the second aperture; depositing the molding compound in a layer over the leadframe and the one or more microelectronic components, the first and second pins extending above the layer; curing the molding compound; and, removing the first and second pins, leaving the first and second cavities through the layer.

In another aspect, the present disclosure provides a self-powered microelectronic semiconductor device including: a microelectronics package including a plurality of conductive leads and one or more microelectronic components each electrically connected to at least one of the conductive leads; a layer of molding compound disposed over the microelectronics package and including a plurality of cavities extending through the layer to expose a corresponding plurality of electrical contact surfaces; a battery assembly including a battery and a plurality of terminal connectors electrically connecting positive and negative terminals of the battery to one or more of the plurality of conductive leads via electrical contact of the plurality of terminal connectors to the plurality of electrical contact surfaces, the battery having a tolerance for temperatures up to a maximum temperature, the battery assembly mounted to the microelectronics package at a first temperature that does not exceed the maximum temperature; and, a low temperature encapsulant deposited, at a second temperature that does not exceed the maximum temperature, over the layer of molding compound, the battery assembly, and the microelectronics package to encapsulate the semiconductor device.

The plurality of conductive leads may include a first battery pad and a second battery pad. The plurality of electrical contact surfaces may include a first surface on the first battery pad and a second surface on the second battery. The battery assembly may be mechanically and electrically bonded to the microelectronics package with a low temperature electrically conductive bonding agent bonded, at the first temperature, to the first battery pad and a positive terminal connector of the plurality of terminal connectors, and to the second battery pad and a negative terminal connector of the plurality of terminal connectors.

The microelectronics package may include a leadframe. The plurality of conductive leads may include a first leg of the leadframe, a second leg of the leadframe electrically isolated from the first leg, and a third leg of the leadframe electrically isolated from the first and second legs. The plurality of electrical contact surfaces may include a first surface on the first leg, a second surface on the second leg, and a third surface on the third leg. A first of the plurality of terminal connectors may include a first tab affixed to the first leg of the leadframe; and, a second of the plurality of terminal connectors may include a second tab affixed to the second leg of the leadframe and a third tab affixed to the third leg of the leadframe. The leadframe may further include a plurality of apertures therethrough, the plurality of apertures including: a first aperture through the first leg, the first aperture disposed below a first of the plurality of cavities to form a first tab channel; a second aperture through the second leg, the second aperture disposed below a second of the plurality of cavities to form a second tab channel; and, a third aperture through the third leg, the third aperture disposed below a third of the plurality of cavities to form a third tab channel. The first terminal connector may extend into the first tab channel and the first tab may be affixed to the leadframe within the first aperture. The second terminal connector may extend into the second tab channel, the second tab affixed to the leadframe within the second aperture, and may extend into the third tab channel, the third tab affixed to the leadframe within the third aperture.

The semiconductor device may further include an electrically conductive low temperature bonding agent disposed within the plurality of cavities and mechanically and electrically bonding the plurality of terminal connectors to the corresponding plurality of electrical contact surfaces. The semiconductor device may further include a plurality of apertures each disposed through a corresponding one of the plurality of electrical contact surfaces and aligned with a corresponding one of the plurality of cavities and retaining a corresponding one of the plurality of terminal connectors by friction fit.

In yet another aspect, the present disclosure provides a method of manufacturing a packaged semiconductor device, the method including the steps of: providing a microelectronics package including a plurality of conductive leads and one or more microelectronic components each affixed to one or more of the plurality of conductive leads; forming a plurality of cavities in a molding compound deposited over the plurality of conductive leads and the one or more microelectronic components, the plurality of cavities each extending through the molding compound to expose a corresponding electrical contact surface of a plurality of electrical contact surface each disposed on a corresponding one of the plurality of conductive leads; and, affixing a battery to the microelectronics package, a first terminal of the battery including a first terminal connector extending through a first of the plurality of cavities to affix to a first of the electrical contact surfaces, and a second terminal of the battery including a second terminal connector extending through a second of the plurality of cavities to affix to a second of the electrical contact surfaces.

The microelectronics package may include a leadframe including the plurality of conductive leads and further including a plurality of apertures. Forming the plurality of cavities may include forming the first cavity over a first of the plurality of apertures to create a first channel, and forming the second cavity over a second of the plurality of apertures to create a second channel. Affixing the battery to the microelectronics package may include inserting the first terminal connector through the first channel into the first aperture and inserting the second terminal connector through the second channel into the second aperture. Affixing the battery to the microelectronics package may further include the steps of: depositing an electrically conductive low temperature bonding agent into the first channel and into the second channel, the bonding agent contacting the leadframe within the first and second apertures, respectively, and the bonding agent contacting the first and second terminal connectors when the first and second terminal connectors are inserted into the first and second apertures, respectively; and, causing the bonding agent to bond the first and second terminals in electrical and mechanical contact with the leadframe. The method may further include depositing a low temperature encapsulant over the molding compound and the battery and onto the microelectronics package to encapsulate the semiconductor device.

Although the invention(s) is/are described herein with reference to specific embodiments, various modifications and changes can be made without departing from the scope of the present invention(s), as set forth in the claims below. Accordingly, the specification and figures are to be regarded in an illustrative rather than a restrictive sense, and all such modifications are intended to be included within the scope of the present invention(s). Any benefits, advantages, or solutions to problems that are described herein with regard to specific embodiments are not intended to be construed as a critical, required, or essential feature or element of any or all the claims.

Unless stated otherwise, terms such as "first" and "second" are used to arbitrarily distinguish between the elements such terms describe. Thus, these terms are not necessarily intended to indicate temporal or other prioritization of such elements. Similarly, the description may refer to a left-hand or right-hand bit in any series of bits (e.g., a DAC code or LDO code). It should be understood that such terms are utilized to provide a clear description of an implementation of the invention and that the various bit sequencing may be implemented in any order in memory and, in fact, the multiple bits making up a given code or other word could be implemented in different regions of a memory or across multiple different memory devices. Similar, the present description may describe a stored binary value being set when having a signal value greater than a threshold and cleared when the cell's signal value is less than that threshold. It will be apparent to the person of ordinary skill in the art that such definitions may be reversed so that a particular cell may be set when its signal value falls below a threshold and the cell is cleared when its value falls above the same or a different threshold.

The term "coupled" is defined as connected, although not necessarily directly, and not necessarily mechanically. The terms "a" and "an" are defined as one or more unless stated otherwise. The terms "comprise" and any form of comprise, such as "comprises" and "comprising"), "have" (and any form of have, such as "has" and "having"), "include" (and any form of include, such as "includes" and "including") and "contain" (and any form of contain, such as "contains" and "containing") are open-ended linking verbs. As a result, a system, device, or apparatus that "comprises," "has," "includes" or "contains" one or more elements possesses those one or more elements but is not limited to possessing only those one or more elements. Similarly, a method or process that "comprises," "has," "includes" or "contains" one or more operations possesses those one or more operations but is not limited to possessing only those one or more operations.

## Claims

1. A method of manufacturing a semiconductor device, the method comprising:
providing a microelectronics package comprising one or more microelectronic components affixed to a leadframe;
forming a plurality of cavities in a molding compound deposited over the leadframe and the one or more microelectronic components, the plurality of cavities each extending through the molding compound to expose a portion of the leadframe;
affixing a battery assembly to the leadframe, the battery assembly comprising:
a battery including a first terminal and a second terminal;
a first terminal connector attached to the first terminal of the battery and extending through a first of the plurality of cavities to affix to a first leg of the leadframe; and
a second terminal connector attached to the second terminal of the battery and extending through a second of the plurality of cavities to affix to a second leg of the leadframe; and
depositing a low temperature encapsulant over the molding compound, the battery assembly, and the leadframe to encapsulate the semiconductor device.

2. The method of claim 1, further
comprising affixing the one or more microelectronic components to the leadframe.

3. The method of claim 1 or 2, wherein forming the plurality of cavities comprises:
positioning a plurality of structures on an upper surface of the leadframe at locations that correspond to at least the first and second terminal connectors of the battery assembly;
depositing the molding compound in a layer over the leadframe and the one or more microelectronic components, the plurality of structures extending above the layer;
curing the molding compound; and
removing the plurality of structures, leaving the plurality of cavities through the layer.

4. The method of any preceding claim, wherein the battery has a tolerance for temperatures up to a maximum temperature, and wherein affixing the battery assembly to the leadframe comprises:
depositing an electrically conductive low temperature bonding agent into the first cavity and into the second cavity, the bonding agent contacting the leadframe;
inserting the first terminal connector and the second terminal connector into the first and second cavities, respectively, into contact with the bonding agent; and
causing the bonding agent to bond the first and second terminals in electrical and mechanical contact with the leadframe at a temperature that does not exceed the maximum temperature.

5. The method of claim 4, wherein the low temperature bonding agent is electrically conductive adhesive (ECA), and wherein causing the bonding agent to bond the first and second terminals comprises curing the ECA.

6. The method of claim 4 or 5, wherein the low temperature bonding agent is a low temperature solder, the first and second terminal connectors comprise tin plating, and causing the bonding agent to bond the first and second terminals comprises reflowing the solder and the tin plating into each other.

7. The method of any preceding claim, wherein:
the leadframe comprises a plurality of apertures including a first aperture disposed through the first leg and a second aperture disposed through the second leg;
forming the plurality of cavities comprises forming the first cavity over the first aperture to create a first channel and forming the second cavity over the second aperture to create a second channel; and
affixing the battery assembly to the leadframe comprises inserting the first terminal connector through the first channel into the first aperture and inserting the second terminal connector through the second channel into the second aperture.

8. The method of claim 7, wherein affixing the battery assembly to the leadframe comprises inserting the first and second terminal connectors into the first and second apertures, respectively, to secure the first and second terminal connectors to the leadframe by friction fit.

9. The method of claim 7 or 8, wherein affixing the battery assembly to the leadframe further comprises:
depositing an electrically conductive low temperature bonding agent into the first channel and into the second channel, the bonding agent contacting the leadframe within the first and second apertures, respectively, and the bonding agent contacting the first and second terminal connectors when the first and second terminal connectors are inserted into the first and second apertures, respectively; and
causing the bonding agent to bond the first and second terminal connectors in electrical and mechanical contact with the leadframe.

10. A self-powered microelectronic semiconductor device comprising:
a microelectronics package comprising a plurality of conductive leads and one or more microelectronic components each electrically connected to at least one of the conductive leads;
a layer of molding compound disposed over the microelectronics package and comprising a plurality of cavities extending through the layer to expose a corresponding plurality of electrical contact surfaces;
a battery assembly comprising a battery and a plurality of terminal connectors electrically connecting positive and negative terminals of the battery to one or more of the plurality of conductive leads via electrical contact of the plurality of terminal connectors to the plurality of electrical contact surfaces, the battery having a tolerance for temperatures up to a maximum temperature, the battery assembly mounted to the microelectronics package at a first temperature that does not exceed the maximum temperature; and
a low temperature encapsulant deposited, at a second temperature that does not exceed the maximum temperature, over the layer of molding compound, the battery assembly, and the microelectronics package to encapsulate the semiconductor device.

11. The semiconductor device of claim 10, wherein:
the plurality of conductive leads comprises a first battery pad and a second battery pad;
the plurality of electrical contact surfaces includes a first surface on the first battery pad and a second surface on the second battery pad; and
the battery assembly is mechanically and electrically bonded to the microelectronics package with a low temperature electrically conductive bonding agent bonded, at the first temperature, to the first battery pad and a positive terminal connector of the plurality of terminal connectors, and to the second battery pad and a negative terminal connector of the plurality of terminal connectors.

12. The semiconductor device of claim 11, wherein:
the microelectronics package comprises a leadframe;
the plurality of conductive leads includes a first leg of the leadframe, a second leg of the leadframe electrically isolated from the first leg, and a third leg of the leadframe electrically isolated from the first and second legs;
the plurality of electrical contact surfaces includes a first surface on the first leg, a second surface on the second leg, and a third surface on the third leg;
a first of the plurality of terminal connectors comprises a first tab affixed to the first leg of the leadframe; and
a second of the plurality of terminal connectors comprises a second tab affixed to the second leg of the leadframe and a third tab affixed to the third leg of the leadframe.

13. The semiconductor device of claim 12, wherein:
the leadframe further comprises a plurality of apertures therethrough, the plurality of apertures including:
a first aperture through the first leg, the first aperture disposed below a first of the plurality of cavities to form a first tab channel;
a second aperture through the second leg, the second aperture disposed below a second of the plurality of cavities to form a second tab channel; and
a third aperture through the third leg, the third aperture disposed below a third of the plurality of cavities to form a third tab channel;
the first terminal connector extends into the first tab channel and the first tab is affixed to the leadframe within the first aperture; and
the second terminal connector extends into the second tab channel, the second tab affixed to the leadframe within the second aperture, and extends into the third tab channel, the third tab affixed to the leadframe within the third aperture.

14. The semiconductor device of any of claims 10 to 13, further comprising an electrically conductive low temperature bonding agent disposed within the plurality of cavities and mechanically and electrically bonding the plurality of terminal connectors to the corresponding plurality of electrical contact surfaces.

15. The semiconductor device of any of claims 10 to 14, further comprising a plurality of apertures each disposed through a corresponding one of the plurality of electrical contact surfaces and aligned with a corresponding one of the plurality of cavities and retaining a corresponding one of the plurality of terminal connectors by friction fit.
